# EUROPÄISCHE PATENTSCHRIFT

(11) **EP 0 609 261 B1**
(45) Veröffentlichungstag und Bekanntmachung des Hinweises auf die Patenterteilung: **18.10.1995**
(21) Anmeldenummer: 92920726.4
(22) Anmeldetag: 12.10.1992
(51) Int. Cl.: G01R 31/34, G01M 15/00, G21C 17/00

(54) **EINRICHTUNG ZUR ÜBERPRÜFUNG EINES ELEKTRISCHEN ANTRIEBS**
DEVICE FOR TESTING AN ELECTRICAL DRIVE UNIT
SYSTEME DE CONTROLE D'UN SYSTEME DE COMMANDE ELECTRIQUE

(30) Priorität: 25.10.1991 DE 4135287
(43) Veröffentlichungstag der Anmeldung: 10.08.1994
(73) Patentinhaber: SIEMENS AKTIENGESELLSCHAFT, 80333 München (DE)
(72) Erfinder: KUTZER, Heinz, D-6457 Maintal 1 (DE)
(86) Internationale Anmeldenummer: DE9200857
(87) Internationale Veröffentlichungsnummer: WO9308482

(56) Entgegenhaltungen:
- EP-A- 0 120 749
- EP-A- 0 301 358
- EP-A- 0 355 255
- GB-A- 2 239 320
- US-A- 4 616 179
- Derwent's abstract, no 91-123 651/17, Woche 9117, Zusammenfassung von SU 1 450 607, (I.Z. SKRYPIN), 1990-09-23
- Patent Abstracts of Japan, Band 12, Nr 86, P-677,, Zusammenfasung von JP, 62- 218883 (HIKARI SHOKO K.K.),
- Patent Abstracts of Japan, Band 11, Nr 252, P-605,, Zusammenfasung von JP, 62- 56876 (SUMITOMO METAL INC LTD),

## Beschreibung

Die Erfindung betrifft eine Einrichtung zur Überprüfung eines elektrischen Antriebs, insbesondere eines Antriebs einer Armatur, wobei elektrische Versorgungsleitungen des Antriebs durch einen dem Antrieb zugeordneten Einschub einer Schaltanlage verlaufen und wobei am Einschub Abgriffe für eine Meß- und Auswerteeinheit angeordnet sind.

Durch eine Überprüfung eines elektrischen Antriebs einer Armatur wird der Funktionszustand der Armatur überwacht. Dadurch können rechtzeitig Störungen oder Veränderungen im Betriebsverhalten der Armatur erkannt werden. Solche Störungen beeinträchtigen die Zuverlässigkeit der Armatur noch nicht, könnten aber einen sicherheitsrelevanten Schaden an der Armatur nach sich ziehen. Durch das rechtzeitige Erkennen der Störung kann die Armatur rechtzeitig gezielt repariert oder ausgetauscht werden. Es kommt folglich nicht zu sicherheitsrelevanten Schäden, die insbesondere in Anlagen mit hohen Sicherheits- oder Verfügbarkeitsanforderungen vermieden werden müssen. Solche Anlagen können Kernkraftwerke oder Produktionsanlagen oder chemische Anlagen sein.

Elektrische Versorgungsleitungen eines Antriebs sind üblicherweise durch einen Einschub einer Schaltanlage verlaufend angeordnet. Ein solcher Einschub ist aus Brockhaus Naturwissenschaften und Technik, Band 1, 1983, Seite 302, bekannt. Ein derartiger Einschub steht für jeden Antrieb zur Verfügung. In einem solchen Einschub befindet sich eine Steuereinheit, sowie andere elektronische Bauteile. Dort sind außerdem eine Spannungsversorgungseinheit und Schütze für den Antrieb angeordnet.

Ein Prüfverfahren und ein Prüfgerät für einen elektrischen Antrieb ist aus der DE 29 17 529 C2 bekannt.

Aus der EP 0 301 358 Al ist ein Verfahren zur Überprüfung eines Antriebes bekannt, bei dem ein Widerstand zur Messung der Stromstärke in den Stromkreis des Antriebes eingeschaltet wird. Dadurch wird der Betrieb des Antriebes während des Meßvorganges beeinträchtigt.

Aus der EP 0 355 255 A2 ist bekannt, daß auf ein Aggregat zu Meßzwecken ein Baustein aufgesteckt wird. Durch diesen Baustein, der elektrische und elektronische Bestandteile enthält, wird die Arbeitsweise des Aggregats während der Messung beeinträchtigt.

Mit den bekannten Verfahren und Einrichtungen ist entweder die Verfügbarkeit des Antriebs und insbesondere einer Armatur durch die erforderlichen Prüfungen eingeschränkt oder es muß zum Prüfen des Antriebs in den Betrieb der den Antrieb enthaltenden Anlage eingegriffen werden. Daher kann, um die Störung des Betriebs geringzuhalten, nur in zeitlichen Abständen eine Prüfung durchgeführt werden. Daraus folgt, daß einzelne zwischen den Prüfungen auftretende Störungen nicht erkannt werden können.

Falls dem zu überprüfenden Antrieb ein Einschub, der beispielweise aus Brockhaus Naturwissenschaften und Technik bekannt ist, zugeordnet ist, ist es üblich, daß, um eine Überprüfung eines Antriebs durchzuführen, der entsprechende Einschub aus der Schaltanlage herausgenommen und durch einen Meßeinschub ersetzt wird.

Der Antrieb wird also von seiner eigentlichen Aufgabe entbunden. Eine durch den Antrieb bewegte Armatur wird stillgesetzt, damit in einem begrenzten Meßprüflauf der Antrieb geprüft werden kann.

Es kann notwendig sein, daß nach dem Entfernen des Einschubs ein Adaptereinschub eingesetzt wird, mit dem Meßvorrichtungen verbunden werden können.

Ein bekannter Meßeinschub oder ein Adaptereinschub enthalten eine andere Verkabelung als ein für den Dauerbetrieb bestimmter Einschub. Im Meßeinschub befinden sich an den elektrischen Versorgungsleitungen des Antriebs Leitungsanbindungen für die Spannungsmessung. Diese Leitungen sind mit als Steckkontakte ausgebildeten Spannungsabgriffen am Meßeinschub verbunden. Für die Stromstärkemessung sind die Versorgungsleitungen im Meßeinschub unterbrochen. Die beiden Enden einer Leitung stehen mit einem Stromabgriff in der Form von Steckkontakten am Meßeinschub in Verbindung.

Vom Einschub für den üblichen Betrieb des Antriebs unterscheidet sich der Meßeinschub insbesondere dadurch, daß die Versorgungsleitungen für die Stromstärkemessung unterbrochen sind.

An den Spannungs- und Stromabgriffen des Meßeinschubs wird in der Regel eine Meß- und Auswerteeinheit angeschlossen, in der aus Spannung und Stromstärke die Wirkleistung bestimmt wird, die ein Maß für den Zustand einer Armatur ist.

Das bekannte Verfahren und die zur Durchführung geeignete Einrichtung sind aufwendig und schwer handhabbar. Für jede Überprüfung muß nicht nur der zu überprüfende Antrieb außer Betrieb sein, was den Betrieb der Gesamtanlage tangiert, es muß darüber hinaus der dem Antrieb zugeordnete Einschub in der Schaltanlage durch einen Meßeinschub oder durch einen Adaptereinschub ersetzt werden. Das häufige Auswechseln von Einschüben in der Schaltanlage kann zu Beschädigungen der Einschübe oder der Schaltanlage führen. Ein Weiterbetrieb des Antriebs und damit einer Armatur während des Prüfvorgangs ist nicht möglich, da beim Auswechseln der Einschübe die Versorgungsleitungen unterbrochen werden.

Der Erfindung lag die Aufgabe zugrunde, eine Einrichtung zur Überprüfung eines elektrischen Antriebs, insbesondere eines Antriebs einer Armatur, anzugeben, die nicht nur an einem zuvor stillgesetzten Antrieb eingesetzt werden kann. Vielmehr soll eine Überprüfung des Antriebs fortlaufend während des üblichen Einsatzes des Antriebs möglich sein. Es sollen darüber hinaus keine schwerwiegenden Eingriffe in die Anlage, insbesondere in die Versorgungsleitungen des Antriebs erforderlich sein. Ein Antrieb soll während seiner Prüfung ständig verfügbar bleiben.

Die Aufgabe, eine Einrichtung zur Überprüfung eines elektrischen Antriebs anzugeben, wird gemäß der Erfindung dadurch gelöst, daß im Einschub von den Versorgungsleitungen Spannungsmeß ausgehen, die an Spannungsabgriffen enden, daß im Einschub den Versorgungsleitungen Stromwandler ohne Unterbrechung der Versorgungsleitungen zugeordnet sind und daß die Stromwandler über Strommeßleitungen mit Stromabgriffen verbunden sind.

Damit wird einerseits der Vorteil erzielt, daß zur Überprüfung ein Auswechseln von Einschüben nicht erforderlich ist. Es kommt nicht zu einem durch die Überprüfung bedingten Stillstand des Antriebs. Die Überprüfung kann vielmehr laufend während des normalen Einsatzes des Antriebs erfolgen. Andererseits wird der Vorteil erzielt, daß während einer Überprüfung kein Eingriff in die Funktionsweise des Antriebs erfolgt. Das ist auf den Einsatz von einem oder mehreren Stromwandlern an den Versorgungsleitungen zurückzuführen. Ein solcher Einsatz von Stromwandlern in einem Einschub war bisher von Fauchleuten als unmöglich angesehen worden. Die Stromwandler sind mit der Meß- und Auswerteeinheit zu verbinden.

Ein solcher Stromwandler kann für Wechselstrom ein induktiver Stromwandler und für Gleichstrom ein Hall-Generator sein. Auch eine Spannungsmessung an einem bekannten Shunt, der in der Versorgungsleitung angeordnet ist, kann zum Bestimmen der Stromstärke dienen.

Erst durch einen Einsatz eines Stromwandlers kann man ohne besonderen Meßeinschub auskommen. Aufgrund der Stromwandler braucht nämlich die Versorgungsleitung zur Stromstärkemessung nicht unterbrochen zu werden. Eine Ankopplung für eine Stromstärkemessung durch Stromwandler stört, wenn keine Überprüfung erfolgen soll, den Stromfluß durch die Versorgungsleitungen nicht. Mit dem Stromwandler können kurzfristig Stromstärkemessungen vorgenommen werden. Es ist sogar eine laufende Überprüfung des Antriebs möglich. Durch die laufende Überprüfung des Antriebs können vorteilhafterweise auch nur zeitweise und kurzzeitig auftretende Störungen erkannt werden.

Mit der Einrichtung nach der Erfindung wird der Vorteil erzielt, daß durch Spannungs- und Stromstärkemessung die Integrität der Versorgungsleitungen nicht beeinflußt wird. Insbesondere gilt das bei einem Wechselstromantrieb, bei dem beispielsweise induktive Stromwandler eingesetzt sind, wofür die Versorgungsleitungen unverletzt bleiben können. Da die Versorgungsleitungen durch die Überprüfung nicht beeinträchtigt werden, kann der gleiche Einschub gleichzeitig zum Betrieb und zur Überprüfung des Antriebs verwendet werden. Es kann sogar während des Betriebs eine Überprüfung erfolgen.

Der Einsatz eines induktiven Stromwandlers in einem solchen Einschub war bisher unmöglich, da keine ausreichend kleinen Stromwandler zur Verfügung standen, die in einem Einschub mit vorgegebener Größe hätten untergebracht werden können. Erst gezielt für den Einsatz in der Einrichtung gemäß der Erfindung entwickelte ausreichend klein dimensionierte Stromwandler ermöglichen den Aufbau der Einrichtung zur Überprüfung eines elektrischen Antriebs gemäß der Erfindung. Entsprechend ermöglichen erst die kleinen Stromwandler die Durchführung des Verfahrens nach der Erfindung.

Bei einem Gleichstromantrieb sind den Versorgungsleitungen Gleichstromwandler zugeordnet. Ein geeigneter Gleichstromwandler ist beispielsweise ein Hall-Generator. Die üblichen Gleichstromwandler arbeiten wie die induktiven Stromwandler berührungslos. Es kann also auch bei einem Gleichstromantrieb der gleiche Einschub gleichzeitig zum Betrieb und zur Überprüfung des Antriebs verwendet werden.

Falls bei einem Gleichstromantrieb die Versorgungsleitungen Shunts, das sind Widerstände im Milliohm-Bereich, enthalten, können beiderseits eines Shunts, der dann als Stromwandler dient, von einer Versorgungsleitung jeweils eine Shunt-Spannungsmeßleitung ausgehen, die an den Stromabgriffen enden. In der Auswerteeinheit ist dann bei bekannten Eigenschaften des Shunts, insbesondere bei bekanntem Widerstand des Shunts, aus der Spannung am Shunt die Stromstärke in der Versorgungsleitung bestimmbar. In Verbindung mit der Auswerteeinheit dient der Shunt dabei als Stromwandler und die Shunt-Spannungsmeßleitungen dienen als Strommeßleitungen.

Den Spannungsabgriffen und den Stromabgriffen am Einschub ist beispielsweise ein Diagnosestecker zugeordnet, der mit der Meß- und Auswerteeinheit verbunden ist. Der Diagnosestecker ist so ausgebildet, daß er auf die Spannungs- und Stromabgriffe des Einschubs paßt. Damit wird der Vorteil erzielt, daß die Meß- und Auswerteeinheit schnell mit einem Einschub zu verbinden und auch schnell wieder vom Einschub zu lösen ist. Das ist sinnvoll, wenn der Diagnosestecker einer Meß- und Auswerteeinheit auf alle Einschübe paßt, die jeweils einem Antrieb zugeordnet sind. Man benötigt dann vorteilhafterweise nur eine Meß- und Auswerteeinheit, durch die nacheinander sämtliche elektrische Antriebe überprüft werden können. Dazu muß nur der Diagnosestecker mit den einzelnen Einschüben nacheinander verbunden werden.

Beispielsweise weist ein Einschub einen Kodierungsabgriff auf, an dem ein Kodierungssignal anliegt, das den Antrieb, dem der Einschub zugeordnet ist, kennzeichnet. Der Diagnosestecker nimmt wie alle Abgriffe auch den Kodierungsabgriff auf. Vom Stecker führt eine Leitung für das Kodierungssignal zur Meß- und Auswerteeinheit. Mit der Kodierung der Einschübe wird der Vorteil erzielt, daß der Meß- und Auswerteeinheit über das Kodierungssignal sofort mitgeteilt wird, mit welchem Einschub der Diagnosestecker momentan verbunden ist. Es können also keine Unklarheiten darüber bestehen, welcher Antrieb momentan überprüft wird.

Nach einem weiteren Beispiel sind im Einschub zwei Pole eines Stromabgriffs leitend miteinander verbunden, solange kein Diagnosestecker auf den Einschub aufgesteckt ist. Erst durch das Aufstecken eines Diagnosesteckers wird diese Verbindung der beiden Pole mechanisch unterbrochen. Damit wird der Vorteil erzielt, daß die induktiven Stromwandler solange sie nicht benötigt werden kurz geschlossen sind.

Mit der Einrichtung gemäß der Erfindung wird insbesondere der Vorteil erzielt, daß während des normalen Betriebs eines Antriebs jederzeit kurzfristig eine Überprüfung dieses Antriebs erfolgen kann, ohne daß in einer Schaltanlage Einschübe ausgewechselt werden müßten. Einer oder mehrere Antriebe können sogar fortlaufend überprüft werden, solange eine Meß- und Auswerteeinheit mit dem entsprechenden Einschub verbunden ist. Auf diese Weise können selbst nur sporadisch auftretende Störungen sicher erkannt werden. Fehler eines Antriebs können schnell und eindeutig erfaßt werden. Es können sogar Trends im Verhalten des Antriebs erkannt werden. Trotzdem bleibt der zu überprüfende Antrieb stets für seine eigentliche Aufgabe verfügbar. Es sind vorteilhafterweise keine Eingriffe in die Anlage, deren Teil der Antrieb ist, erforderlich.

Durch die Kodierung der Einschübe ist sicher und zuverlässig festzustellen, welcher Antrieb momentan geprüft wird.

Die Einrichtung gemäß der Erfindung wird anhand der Zeichnung näher erläutert:
- Figur 1: zeigt einen Einschub, der gemäß der Erfindung gleichzeitig zum Betrieb und zur Überprüfung eines Antriebs verwendet werden kann.
- Figur 2: zeigt einen Ausschnitt aus einer anderen Ausführungsform eines solchen Einschubes.

Ein Antrieb 1, der ein Antriebsmotor einer Armatur sein kann, ist über Versorgungsleitungen 2 mit einer Spannungsquelle U verbunden. Eine Schaltanlage weist für jeden Antrieb 1 einen Einschub 3 auf. In einem solchen Einschub 3 erfolgt die Steuerung des Antriebs 1, indem durch Anlegen von Steuerspannungen U_{St} Schalter/Schütze 4 in den Versorgungsleitungen 2 geöffnet oder geschlossen werden.

Im Einschub 3 gemäß der Erfindung gehen von den Versorgungsleitungen 2 jeweils eine Spannungsmeßleitung 5 aus, die an Spannungsabgriffen 6 enden. In den Spannungsmeßleitungen 5 sind Sicherungen 7 eingeschaltet.

Zur Messung der Stromstärke in den Versorgungsleitungen 2 sind diesen jeweils ein Stromwandler 8 zugeordnet. Falls der Antrieb 1 ein Wechseltromantrieb ist, ist der Stromwandler 8 ein induktiver Stromwandler. Falls der Antrieb 1 ein Gleichstromantrieb ist, ist der Stromwandler 8 ein Gleichstromwandler, z.B. ein Hall-Generator. Diese Stromwandler 8, insbesondere induktive Stromwandler, sind so dimensioniert, daß sie in einem üblichen Einschub 3 untergebracht werden können. Solche kleinen Stromwandler sind bisher nicht bekannt gewesen. Die Stromwandler 8 sind über jeweils zwei Strommeßleitungen 9a und 9b mit Stromabgriffen 10a und 10b verbunden.

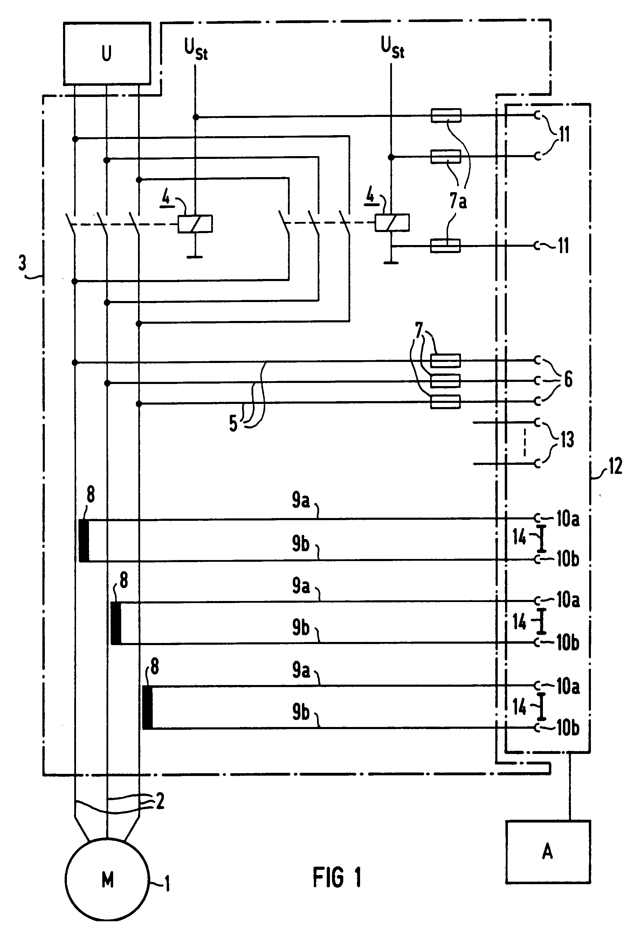

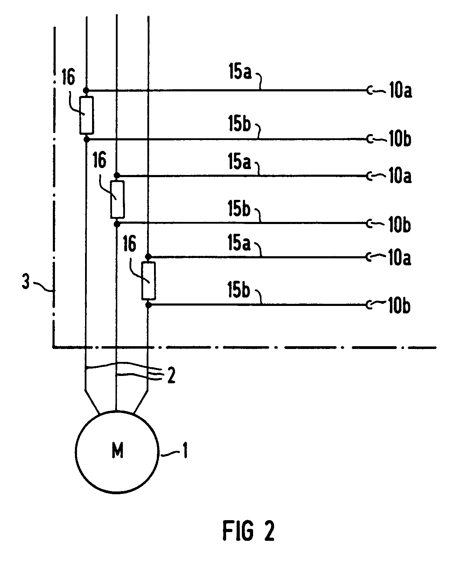

Als "Stromwandler" kann gemäß Figur 2 auch ein Shunt 16 dienen, der mit zwei Shunt-Spannungsmeßleitungen 15a, 15b verbunden ist, die die Funktion von Strommeßleitungen haben. Bei einem Gleichstrom-Antrieb 1 sind in den Versorgungsleitungen 2 häufig Widerstände im Milliohm-Bereich, sogenannte Shunts 16, angeordnet. An einem solchen Shunt 16 wird durch die Shunt-Spannungsmeßleitungen 15a, 15b eine Spannung abgegriffen. Diese Shunt-Spannungsmeßleitungen 15, 15b enden an den Stromabgriffen 10a, 10b. In einer Meß- und Auswerteeinheit kann aus der am Shunt 16 gemessenen Spannung mittels der bekannten Eigenschaften des Shunts 16, wie elektrischer Widerstand, Windungszahl etc., die Stromstärke in der Versorgungsleitung 2 bestimmt werden. Der Einschub 3 (Figur 1) kann auch Abgriffe 11 für die Steuerspannung U_{St} aufweisen. Diesen Abgriffen 11 sind Sicherungen 7a zugeordnet.

Mit einem Einschub 3 kann ein Diagnosestecker 12 verbunden werden, der mit allen Abgriffen 6, 10a, 10b und gegebenenfalls 11 in Kontakt tritt. Der Diagnosestecker 12 ist mit einer Meß- und Auswerteeinheit A z.B. über Kabel verbunden. Dort werden die Spannungen an den Spannungsabgriffen 6 und die Stromstärken an den Stromabgriffen 10a, 10b gemessen oder bestimmt. Aus diesen beiden Werten wird in bekannter Weise die Wirkleistung bestimmt, die ein Maß für den Zustand des Antriebs 1 ist. Eine von einem Sollwert abweichende Wirkleistung ist ein Hinweis auf eine Störung im Antrieb 1, die behoben werden muß. Ein Vergleich der einzelnen Stromstärken und zeitlichen Stromverläufe an verschiedenen Versorgungsleitungen 2 zugeordneten Stromabgriffen 10a, 10b untereinander ergibt einen Hinweis auf den Wicklungszustand des Antriebsmotors. Die Steuerspannungsabgriffe 11 können ebenfalls mit der Meß- und Auswerteeinheit A, die eine Anzeigeeinheit umfassen kann, verbunden sein. Die Steuerspannungen können in Verbindung mit der Wirkleistung oder mit den Spannungen an den Spannungsabgriffen 6 oder mit den Strömen an den Stromabgriffen 10a, 10b zur Ermittlung und Beurteilung der Schaltzeiten der Schalter bzw. Schütze 4 herangezogen werden.

In einer Schaltanlage befinden sich viele Einschübe 3. Jeder Einschub 3 ist einem bestimmten Antrieb 1 zugeordnet. Um erkennen zu können, zu welchem Antrieb 1 ein bestimmter Einschub 3 gehört, weist dieser einen Kodierungsabgriff 13 auf, an dem eine Kodierungsschaltung anliegt. Die Kodierungsschaltung kennzeichnet den Einschub 3 und damit den Antrieb 1. Der Diagnosestecker 12 enthält auch Vorrichtungen zum Ankoppeln an den Kodierungsabgriff 13. Vom Diagnosestecker 12 ausgehend ist neben den übrigen Abgriffen auch der Kodierungsabgriff 13 mit der Meß- und Auswerteeinheit A verbunden. Die Kodierungsschaltung wird von der Meß- und und Auswerteeinheit A abgefragt und zeigt dort eindeutig an, welcher Antrieb 1 momentan überprüft wird.

Die beiden Stromabgriffe 10a und 10b eines Stromwandlers 8 sind, wenn kein Diagnosestecker 12 auf dem Einschub 3 aufgesteckt ist, durch eine Kurzschlußbrücke 14 leitend miteinander verbunden. Diese Kurzschlußbrücke 14 wird beim Aufstecken des Diagnosesteckers 12 auf den Einschub 3 mechanisch unterbrochen.

Der dargestellte Einschub 3 gemäß der Erfindung dient gleichzeitig zum Betrieb und zur Überwachung des Antriebs 1. Für eine Überprüfung des Antriebs 1 ist kein Auswechseln eines Einschubes 3 mehr erforderlich. Der Antrieb 1 kann laufend überprüft werden, wodurch Störungen des Antriebs 1 schnell und zuverlässig erkannt werden können.

## Patentansprüche

1. Einrichtung zur Überprüfung eines elektrischen Antriebs (1), insbesondere eines Antriebs (1) einer Armatur, wobei elektrische Versorgungsleitungen (2) des Antriebs (1) durch einen dem Antrieb (1) zugeordneten Einschub (3) einer Schaltanlage verlaufen und wobei am Einschub (3) Abgriffe für eine Meß- und Auswerteeinheit (A) angeordnet sind, **dadurch gekennzeichnet**, daß im Einschub (3) von den Versorgungsleitungen (2) Spannungsmeßleitungen (5) ausgehen, die an Spannungsabgriffen (6) enden, daß im Einschub (3) den Versorgungsleitungen (2) Stromwandler (8; 16) ohne Unterbrechung der Versorgungsleitungen (2) zugeordnet sind und daß die Stromwandler (8, 16) über Strommeßleitungen (9a, 9b; 15, 15b) mit Stromabgriffen (10a, 10b) verbunden sind.

2. Einrichtung nach Anspruch 1,
**dadurch gekennzeichnet**, daß der Antrieb (1) ein Wechselstromantrieb ist und daß den Versorgungsleitungen (2) Stromwandler (8) induktiv zugeordnet sind.

3. Einrichtung nach Anspruch 1,
**dadurch gekennzeichnet**, daß der Antrieb (1) ein Gleichstromantrieb ist und daß den Versorgungsleitungen (2) Gleichstromwandler (8) zugeordnet sind.

4. Einrichtung nach Anspruch 3,
**dadurch gekennzeichnet**, daß den Versorgungsleitungen (2) als Gleichstromwandler (8) Hall-Generatoren zugeordnet sind.

5. Einrichtung nach Anspruch 3,
wobei die Versorgungsleitungen Shunts (16) aufweisen, **dadurch gekennzeichnet**, daß die Shunts (16) als Stromwandler dienen, daß dazu beiderseits eines Shunts (16) von einer Versorgungsleitung (2) jeweils eine Shunt-Spannungsmeßleitung (15a, 15b) ausgeht, die an den Stromabgriffen (10a, 10b) enden, und daß in der Auswerteeinheit (A) bei bekannten Eigenschaften des Shunts (16) aus der Shuntspannung die Stromstärke bestimmbar ist.

6. Einrichtung nach einem der Ansprüche 1 bis 5,
**dadurch gekennzeichnet**, daß den Spannungsabgriffen (6) und den Stromabgriffen (10a, 10b) am Einschub (3) ein Diagnosestecker (12) zugeordnet ist, der mit der Meß- und Auswerteeinheit (A) verbunden ist.

7. Einrichtung nach Anspruch 6,
**dadurch gekennzeichnet**, daß der Einschub (3) einen Kodierungsabgriff (13) aufweist, an dem eine Kodierungssschaltung anliegt, die den Antrieb (1), dem der Einschub (3) zugeordnet ist, kennzeichnet, und daß der Diagnosestecker (12) dem Kodierungsabgriff (13) zugeordnet ist zum Weiterleiten eines Kodierungssignals der Kodierungsschaltung an die Meß- und Auswerteeinheit (A).

8. Einrichtung nach einem der Ansprüche 6 oder 7,
**dadurch gekennzeichnet**, daß im Einschub (3) zwei Pole eines Stromabgriffs (10a, 10b) leitend durch eine Kurzschlußbrücke (14) miteinander verbunden sind und daß diese Verbindung bei auf den Einschub (3) aufgestecktem Diagnosestecker (12) unterbrochen ist.

## Claims

1. Device for testing an electrical drive (1), in particular a drive (1) of an armature, wherein electric supply lines (2) of the drive (1) extend through a switchgear plug-in unit (3) which is associated with the drive (1) and wherein taps for a measuring and evaluating unit (A) are arranged at the plug-in unit (3), characterised in that in the plug-in unit (3) there issue from the supply lines (2) voltage-measuring lines (5) which end at voltage taps (6), in that in the plug-in unit (3) current transformers (8; 16) are associated with the supply lines (2) without interruption of the supply lines (2), and in that the current transformers (8, 16) are connected to current taps (10a, 10b) by way of current-measuring lines (9a, 9b; 15, 15b).

2. Device according to claim 1, characterised in that the drive (1) is an alternating current drive and in that current transformers (8) are inductively associated with the supply lines (2).

3. Device according to claim 1, characterised in that the drive (1) is a direct current drive and in that direct current transformers (8) are associated with the supply lines (2).

4. Device according to claim 3, characterised in that Hall generators, as direct current transformers (8), are associated with the supply lines (2).

5. Device according to claim 3, wherein the supply lines have shunts (16), characterised in that the shunts (16) are used as current-transformers, in that for this purpose issuing from a supply line (2), on both sides of a shunt (16), there is a respective shunt voltage-measuring line (15a, 15b), ending at the current taps (10a, 10b), and in that in the evaluating unit (A) given known properties of the shunt (16) it is possible to determine the current intensity from the shunt voltage.

6. Device according to one of the claims 1 to 5, characterised in that associated with the voltage taps (6) and the current taps (10a, 10b) at the plug-in unit (3) there is a diagnostic connector (12) which is connected to the measuring and evaluating unit (A).

7. Device according to claim 6, characterised in that the plug-in unit (3) has a coding tap (13) to which there is applied a coding circuit arrangement which characterises the drive (1) with which the plug-in unit (3) is associated, and in that the diagnostic connector (12) is associated with the coding tap (13) for the purpose of routing a coding signal of the coding circuit arrangement to the measuring and evaluating unit (A).

8. Device according to one of the claims 6 or 7, characterised in that in the plug-in unit (3) two poles of a current tap (10a, 10b) are connected with each other in a conductive manner by means of a short-circuit bridge (14) and in that this connection is interrupted when the diagnostic connector (12) is plugged onto the plug-in unit (3).

## Revendications

1. Système de contrôle d'un système de commande électrique (1), notamment d'une commande (1) d'une armature, des lignes d'alimentation en courant électrique (2) de la commande (1) traversant un tiroir (3) d'une installation de distribution qui est associé à cette commande (1) et le tiroir (3) étant pourvu de prises pour une unité de mesure et d'analyse (A), caractérisé en ce que, dans le tiroir, des lignes de mesure de la tension (5) partent des lignes d'alimentation (2) et se terminent au niveau de prises de tension (6), en ce que, dans le tiroir (3), des transformateurs de courant (8; 16) sont adjoints aux lignes d'alimentation (2), sans interruption de ces dernières (2), et en ce que les transformateurs de courant (8, 16) sont reliés à des prises de courant (10a, 10b) par l'intermédiaire de lignes de mesure du courant (9a, 9b; 15, 15b).

2. Système selon la revendication 1, caractérisé en ce que la commande (1) est une commande à courant alternatif et en ce que des transformateurs de courant (8) sont adjoints de manière inductive aux lignes d'alimentation (2).

3. Système selon la revendication 1, caractérisé en ce que la commande (1) est une commande à courant continu et en ce que des transformateurs d'intensité pour courants continus (8) sont adjoints aux lignes d'alimentation (2).

4. Système selon la revendication 3, caractérisé en ce que des générateurs de Hall sont adjoints aux lignes d'alimentation (2) comme transformateurs d'intensité pour courants continus (8).

5. Système selon la revendication 3, dans lequel les lignes d'alimentation comportent des shunts (16), caractérisé en ce que les shunts (16) servent de transformateurs de courant, en ce qu'en plus, de chaque ligne d'alimentation (2) part, sur les deux côtés respectifs d'un shunt (16), une ligne de mesure de tension du shunt (15a, 15b) qui se termine au niveau des prises de courant (10a, 10b), et en ce que dans l'unité d'analyse (A), les caractéristiques du shunt (16) étant connues, I'intensité du courant peut être déterminée à partir de la tension du shunt.

6. Système selon l'une des revendications 1 à 5, caractérisé en ce qu'un contact de diagnostic (12) est adjoint, sur le tiroir (3), aux prises de tension (6) et aux prises de courant (10a, 10b), lequel contact de diagnostic est relié à l'unité de mesure et d'analyse (A).

7. Système selon la revendication 6, caractérisé en ce que le tiroir (3) est pourvu d'une prise de codage (13) à laquelle est associé un circuit de codage qui caractérise la commande (1) pour laquelle le tiroir (3) est prévu, et en ce que le contact de diagnostic (12) est adjoint à la prise de codage (13) pour transmettre un signal de codage du circuit de codage à l'unité de mesure et d'analyse (A).

8. Système selon l'une des revendications 6 ou 7, caractérisé en ce que, dans le tiroir (3), deux pôles d'une prise de courant (10a, 10b) sont mis en connexion conductrice l'un avec l'autre par une barre de cuivre (14) et en ce que cette connexion est coupée lorsque le contact de diagnostic (12) est enfiché sur le tiroir (3).
